# EUROPEAN PATENT APPLICATION

(11) **EP 4 697 913 A1**
(43) Date of publication of application: **18.02.2026**
(21) Application number: 24861794.6
(22) Date of filing: 14.08.2024
(51) Int. Cl.: H10K 59/121

(54) **DISPLAY SUBSTRATE AND DISPLAY DEVICE**

(30) Priority: 08.09.2023 CN 202311160362
(71) Applicant: Boe Technology Group Co., Ltd., Beijing 100015 (CN)
(72) Inventor: XU, Chuanxiang, Beijing 100176 (CN); SHU, Shi, Beijing 100176 (CN); YAO, Qi, Beijing 100176 (CN); YUAN, Guangcai, Beijing 100176 (CN)
(74) Representative: Brötz, Helmut
(86) International application number: PCT/CN2024/111994
(87) International publication number: WO 2025/050950

(57) **Abstract**

The present application relates to a display substrate and a display device. The display substrate comprises: at least one first display area; a second display area located on at least one side of the at least one first display area, the light transmittance of the second display area being smaller than that of the at least one first display area; and a plurality of first sub-pixels located in the at least one first display area, the first sub-pixels each comprising a first light-emitting element and a first pixel circuit, the first pixel circuit being configured to drive the first light-emitting element to emit light, wherein the first pixel circuit comprises a plurality of transistors, and at least one transistor among the plurality of transistors is an oxide transistor. In this way, the light transmittance of the first display area can be improved.

## Description

### TECHNICAL FIELD

The present disclosure relates to the field of display, in particular to display substrates and display devices.

### BACKGROUND

An OLED (Organic Light Emitting Diode) display structure has become the mainstream display structure due to its high color gamut, lightweight, and flexibility. Increasing the screen-to-body ratio has become one of the core themes of mobile phone innovation. Designs for all screen such as the monobrow design, the notch design, the waterdrop design, and the hole design are all aimed at reducing the space occupied by the front camera. The Under-Display-Camera (UDC) is an inevitable trend of the design of all screen. The main reason why the front camera cannot be placed under the screen is that the driving circuit and wires are opaque, resulting in a low overall transmittance of the screen. Therefore, if the camera is placed under the screen, the light transmitted from outside of the screen cannot be received.

### SUMMARY

The purpose of the present disclosure is to provide a display substrate and a display device that can enhance the transparency of the first display region.

According to the first aspect of the embodiments of the present disclosure, a display substrate is provided, including:
at least one first display region, a second display region on at least one side of the at least one first display region, where light transmittance of the second display region is lower than light transmittance of the at least one first display region; and
first sub pixels in the at least one first display region, where each of the first sub pixels includes a first light-emitting element and a first pixel circuit, where the first pixel circuit is configured to drive the first light-emitting element to emit light;
where the first pixel circuit includes transistors, where at least one of the transistors is an oxide transistor.

In some embodiments, the transistors include oxide transistors and do not include polycrystalline silicon transistors.

In some embodiments, the transistors include oxide transistors and polycrystalline silicon transistors, and a number of the polycrystalline silicon transistors is greater than a number of the oxide transistors.

In some embodiments, the first pixel circuit includes a driving transistor, where the driving transistor is a polycrystalline silicon transistor.

In some embodiments, a length of a channel of the driving transistor is greater than or equal to 20um and less than or equal to 40um.

In some embodiments, the first pixel circuit includes a first circuit transistor, a second circuit transistor, and a third circuit transistor, where a first electrode of the first circuit transistor, a gate of the third circuit transistor, and a second electrode of the second circuit transistor are connected, a first electrode of the second circuit transistor is connected to a second electrode of the third circuit transistor, and the third circuit transistor is a driving transistor.

In some embodiments, the first circuit transistor and the second circuit transistor are oxide transistors.

In some embodiments, the first pixel circuit further includes a power line, a first initialization signal line, a second initialization signal line, and a data line;
where the first pixel circuit includes a storage capacitor, a fourth circuit transistor, a fifth circuit transistor, a sixth circuit transistor, and a seventh circuit transistor, where a first electrode of the first circuit transistor is connected to a first electrode plate of the storage capacitor, a second electrode of the first circuit transistor is connected to the first initialization signal line, the power line is connected to a second electrode plate of the storage capacitor and a first electrode of the fifth circuit transistor, a second electrode of the fifth circuit transistor is connected to a first electrode of the third circuit transistor and a second electrode of the fourth circuit transistor, a first electrode of the fourth circuit transistor is connected to the data line, the first electrode of the second circuit transistor is connected to the first electrode of the six circuit transistor, a second electrode of the sixth circuit transistor is connected to a second electrode of the seventh circuit transistor, and a first electrode of the seventh circuit transistor is connected to the second initialization signal line.

In some embodiments, the third circuit transistor is a polycrystalline silicon transistor, and the first circuit transistor, the second circuit transistor, the fourth circuit transistor, the fifth circuit transistor, the sixth circuit transistor, and the seventh circuit transistor are oxide transistors.

In some embodiments, the third circuit transistor includes an active layer, a gate on a side of the active layer, a first electrode and a second electrode of the third circuit transistor that are on a side of the gate away from the active layer, where the first electrode and the second electrode of the third circuit transistor are connected to the active layer; and
the display substrate further includes a first light shielding layer, where the first light shielding layer is on a side of the active layer away from the gate, and an orthographic projection of the third circuit transistor on the display substrate is within an orthographic projection of the first light shielding layer on the display substrate.

In some embodiments, the first light-emitting element includes an anode, a light-emitting layer, and a cathode that are arranged sequentially away from the first pixel circuit;
where an orthographic projection of the third circuit transistor on the display substrate is within an orthographic projection of the anode on the display substrate.

In some embodiments, the display substrate includes a second light shielding layer, where orthographic projections of the first circuit transistor, the second circuit transistor, the fourth circuit transistor, the fifth circuit transistor, the sixth circuit transistor, and the seventh circuit transistor on the display substrate is within an orthographic projection of the second light shielding layer on the display substrate.

In some embodiments, a first electrode and a second electrode of the storage capacitor are both made of transparent conductive materials.

In some embodiments, the display substrate further includes: a gate line, a light emission control signal line, and a reset control signal line, where the gate line is connected to a gate of the second circuit transistor and a gate of the fourth circuit transistor; the light emission control signal line is connected to a gate of the fifth circuit transistor and a gate of the sixth circuit transistor; and the reset control signal line is connected to a gate of the first circuit transistor and a gate of the seventh circuit transistor.

In some embodiments, at least one of the power line, the first initialization signal line, the second initialization signal line, the data line, the gate line, the light emission control signal line, and the reset control signal line is made of a transparent conductive material.

In some embodiments, all of the power line, the first initialization signal line, the second initialization signal line, the data line, the gate line, the light emission control signal line, and the reset control signal line are made of transparent conductive materials.

In some embodiments, the first light-emitting element includes an anode, a light-emitting layer, and a cathode that are arranged sequentially away from the first pixel circuit;
where orthographic projections of at least some segments of the power line, the first initialization signal line, the second initialization signal line, the data line, the gate line, the light emission control signal line, and the reset control signal line on the display substrate overlap with the orthographic projection of the anode on the display substrate, where the at least some segments overlapping with the anode are made of metal materials, and remaining segments are made of transparent conductive materials.

In some embodiments, the display substrate further includes second sub pixels in the second display region, where each of the second sub pixels including a second light emitting element and a second pixel circuit, where the second pixel circuit is configured to drive the second light emitting element to emit light;
where the second pixel circuit includes transistors, where the transistors of the second pixel circuit include oxide transistors and/or polycrystalline silicon transistors.

In some embodiments, the display substrate further includes a transition display region between the at least one first display region and the second display region, where the transition display region surrounds the at least one first display region; and
the display substrate further includes third sub pixels located in the transition display region, where each of the third sub pixels include a third light emitting element and a third pixel circuit, where the third pixel circuit is configured to drive the third light emitting element to emit light; and
where the third pixel circuit includes a power line, a first initialization signal line, a second initialization signal line, a data line, a gate line, a light emission control signal line, and a reset control signal line, where the power line, the first initialization signal line, the second initialization signal line, the data line, the gate line, the light emission control signal line, and the reset control signal line in the third pixel circuit are metal wires, and the third pixel circuit uses same transistors as the first pixel circuit.

In some embodiments, a pixel density of the second sub pixels is greater than a pixel density of the first sub pixels, and the pixel density of the second sub pixels is greater than a pixel density of the third sub pixels; or
a pixel density of the second sub pixels is greater than a pixel density of the third sub pixels, and the pixel density of the third sub pixels is greater than a pixel density of the second sub pixels.

In some embodiments, the number of the first display regions is 2 or 3.

In some embodiments, transmittance of the second display region is lower than transmittance of the transition display region, and the transmittance of the transition display region is lower than transmittance of the at least one first display region.

The second aspect of the embodiments of the present disclosure proposes a display device including a display substrate as described in the above embodiments;
where the display device further includes at least one optical sensor, and the at least one first display region is set respectively corresponding to the at least one optical sensor.

In some embodiments, the at least one optical sensor is one or more of an ambient light sensor, a distance sensor, a camera sensor, or an infrared sensor.

The beneficial technical effect brought by the technical solution provided in the embodiments of the present disclosure is that: by providing at least one oxide transistor in the first sub-pixel of the first display region, the transparency of the first display region can be improved.

### BRIEF DESCRIPTION OF DRAWINGS

In order to more clearly illustrate the technical solutions according to the embodiments of the present disclosure, drawings that need to be used in the description of the embodiments will be briefly introduced below. The drawings in the following description only relate to some embodiments of the present disclosure. For those skilled in the art, other drawings can also be obtained based on these drawings without creative effort.
FIG. 1 is a planar structural schematic diagram of a display substrate according to an embodiment of the present disclosure.
FIG. 2 is a planar structural schematic diagram of a display substrate according to an embodiment of the present disclosure.
FIG. 3 is a schematic cross-sectional diagram from A-A' in FIG. 2.
FIG. 4 is a schematic cross-sectional diagram from B-B' in FIG. 2.
FIG. 5 is a schematic diagram of a display device according to an embodiment of the present disclosure.
FIG. 6 is a schematic cross-sectional diagram from C-C' in FIG. 1.
FIG. 7 is an equivalent circuit diagram of a pixel circuit and a light-emitting device according to an embodiment of the present disclosure.
FIG. 8 is an equivalent circuit diagram of a pixel circuit and a light-emitting device according to an embodiment of the present disclosure.
FIG. 9 is an equivalent circuit diagram of a pixel circuit and a light-emitting device according to an embodiment of the present disclosure.
FIG. 10 is an equivalent circuit diagram of a pixel circuit and a light-emitting device according to an embodiment of the present disclosure.
FIG. 11 is an equivalent circuit diagram of a pixel circuit and a light-emitting device according to an embodiment of the present disclosure.
FIG. 12 is an equivalent circuit diagram of a pixel circuit and a light-emitting device according to an embodiment of the present disclosure.
FIG. 13 is an equivalent circuit diagram of a pixel circuit and a light-emitting device according to an embodiment of the present disclosure.
FIG. 14 is a planar structural schematic diagram of a display substrate according to an embodiment of the present disclosure.
FIG. 15 is a planar structural schematic diagram of a display substrate according to an embodiment of the present disclosure.
FIG. 16 is a planar structural schematic diagram of a display substrate according to an embodiment of the present disclosure.
FIG. 17 is a planar structural schematic diagram of a display substrate according to an embodiment of the present disclosure.

### DETAILED DESCRIPTION

Embodiments will be described in detail here with the examples thereof expressed in the drawings. When the following descriptions involve the drawings, like numerals in different drawings represent like or similar elements unless stated otherwise. Embodiments described in the illustrative examples below are not intended to represent all embodiments consistent with the present disclosure. Rather, they are merely embodiments of devices and methods consistent with some aspects of the present disclosure as recited in the appended claims.

Terms used in the present disclosure is only for the purpose of describing particular embodiments and is not intended to limit the present disclosure. Unless otherwise defined, the technical terms or scientific terms used in the present disclosure shall have the ordinary meanings understood by those skilled in the art to which the present disclosure belongs. The words such as "a" or "one" in the specification and the claims of the present disclosure do not indicate a quantity limitation, but mean that there is at least one. "A plurality of" means two or more. "Includes", "comprises" and similar terms mean that the elements or items listed before "includes" or "comprises" include the elements or items listed after "includes" or "comprises" and their equivalents, and do not exclude other elements or objects. Words such as "connect" or "couple" are not limited to physical or mechanical connections, and can include electrical connections, whether direct or indirect. Words such as "top" and/or "bottom" are only for illustration purposes and are not limited to a single position or spatial orientation. As used in the present disclosure and the appended claims, the singular forms "a", "said" and "the" are intended to include the plural", and "the" are intended to include the plural forms as well, unless the context clearly dictates otherwise. It should further be understood that the term "and/or" as used herein refers to and includes any and all possible combinations of one or more of the associated listed items.

In the present disclosure, triangles, rectangles, trapezoids, pentagons, hexagons, etc. are not strictly defined and can be approximated as triangles, rectangles, trapezoids, pentagons, hexagons, etc. There may be some small deformations caused by tolerances, such as chamfers, arc edges, and deformations.

The term 'approximately' in the present disclosure refers to numerical values within an allowable range of process and measurement errors without strict limitations.

The transistors in the present disclosure can all be triodes, thin-film transistors, field-effect transistors, or other devices with similar characteristics. In the embodiments of the present disclosure, to distinguish the two electrodes of the transistor except for the control electrode, one electrode is referred to as a first electrode, and the other electrode is referred to as a second electrode.

In practical operation, when the transistor is a triode, the control electrode can be a base electrode, the first electrode can be the collector electrode, and the second electrode can be the emitter electrode. Alternatively, the control electrode can be the base electrode, the first electrode can be the emitter electrode, and the second electrode can be the collector electrode.

In practical operation, when the transistor is a thin film transistor or a field-effect transistor, the control electrode can be a gate, the first electrode can be a drain, and the second electrode can be a source. Alternatively, the control electrode can be a gate, the first electrode can be a source, and the second electrode can be a drain.

In the present disclosure, "film" and "layer" can be interchanged. For example, sometimes the term 'conductive layer' can be replaced with 'conductive film'. Similarly, sometimes the term 'insulation film' can be replaced with 'insulation layer'.

The traditional driving circuit is opaque, resulting in a low overall transmittance. Therefore, the camera or other photosensitive devices under the screen cannot receive external light. Therefore, the general practice is generally to adopt the monobrow design, the notch design, the waterdrop design, or the hole design to accommodate the camera or other photosensitive devices, such that external light can enter the camera or other photosensitive devices. However, this approach will occupy the region of the screen, which is not beautiful.

One general solution is to use driving method of Passive Matrix (PM) in the camera region, which reduces the area of opaque regions and increases the area of transparent regions by reducing the number of metal lines and pixel density. However, this approach still cannot meet the needs of shooting from under screen. Due to the absorbing or reflecting materials in the transparent region, the transmittance is very low, such as the semi transparent material Mg/Ag used as the cathode, or the circular polarizer (C-Pol) with a transmittance of less than 50%, which results in very little light (usually<5%) entering the camera through the panel. Further, the presence of metal wires causes diffraction and other phenomena in the light entering the camera, leading to significant differences between the light received by the camera and the light emitting from the outside world, making it difficult to obtain clear images based on sufficient light.

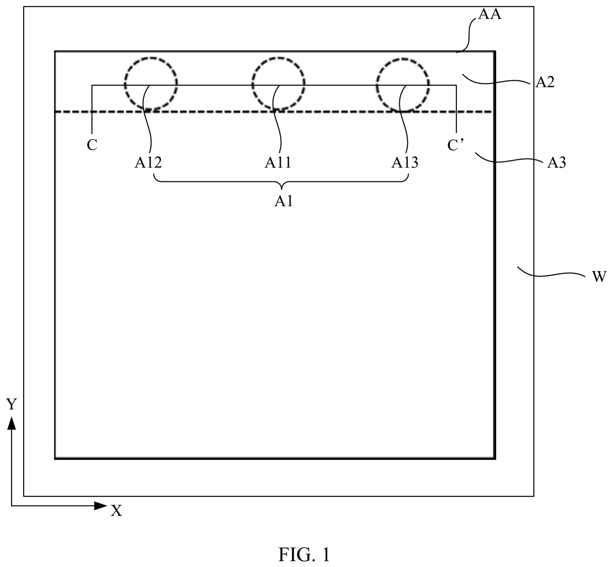

Referring to FIGs. 1-4, the present disclosure provides a display substrate, including: a display region AA and a peripheral region W surrounding the display region AA. The display region AA includes at least one first display region A1 and a second display region A3 on at least one side of the at least one first display region A1. The light transmittance of the second display region A3 is lower than the light transmittance of the at least one first display region A1. Multiple first sub pixels are in the at least one first display region A1. The first sub pixels include a first light-emitting element 21 and a first pixel circuit 11, where the first pixel circuit 11 is configured to drive the first light-emitting element 21 to emit light. The first pixel circuit 11 includes multiple transistors, and at least one of the multiple transistors is an oxide transistor 230.

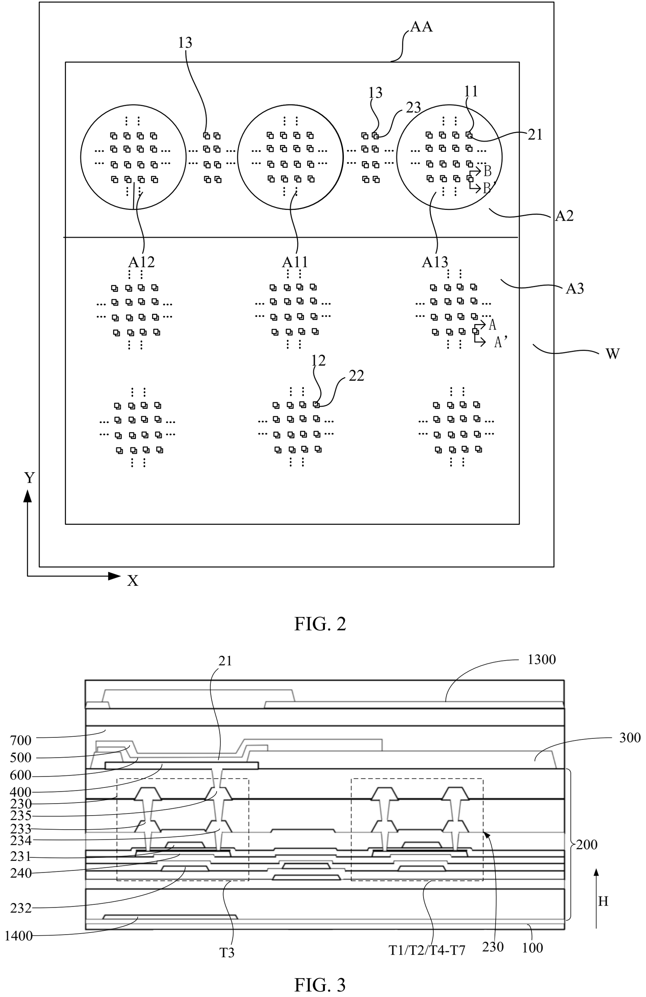

As shown in FIG. 2, the first display region A1 may include a first type display region A11, and second type display regions A12 and A13, etc. The first type display region A11, the second type display regions A12 and A13 contain multiple first sub pixels, where each of the first sub pixels includes a first light-emitting element 21 and a first pixel circuit 11. The first pixel circuit 11 (such as a 7T1C pixel circuit) includes multiple transistors, where at least one transistor is an oxide transistor 230. The oxide transistor 230 here can be made of a material such as indium gallium zinc oxide (IGZO), indium gallium tin oxide (IGTO), indium tin zinc oxide (ITZO), first indium gallium zinc tin oxide (IGZYO, where Y is a rare earth metal element), or second indium gallium zinc tin oxide (IGZXO, where X is a rare earth metal element other than Y), etc. Due to the high transparency of indium zinc oxide (IZO), indium gallium tin oxide (IGTO), indium tin zinc oxide (ITZO), first indium gallium zinc tin oxide (IGZYO), and second indium gallium zinc tin oxide (IGZXO), the oxide transistor 230 has higher transparency compared to the polycrystalline silicon transistor 210, resulting in the first display region A1 of the display substrate having high transparency.

Based on the above description, in the present disclosure the optical sensor can be directly set under the first display region A1 without the need for additional settings such as the monobrow design, the notch design, or the waterdrop design, etc., thereby increasing the screen-to-body ratio, which makes the entire screen more beautiful.

In some examples, the first light-emitting element 21 and the first pixel circuit 11 are set in the same first display region A1, and the first pixel circuit 11 connected to the first light-emitting element 21 is set internally. The second light-emitting element 22 is set in the first display region A1, and the second pixel circuit 12 is set in the transition display region A2. The second pixel circuit 12 connected to the second light-emitting element 22 is set externally.

In some examples, the pixel circuits connected to a portion of the light-emitting elements in the first display region A1 can be set internally, and the pixel circuits connected to the other portion of the light-emitting elements in the first display region A1 can be set in externally. Combining external and internal manners to set pixel circuits within the same first display region A1 is beneficial for increasing the size of the first display region A1, which achieves the optimal combination of light transmittance and size. For example, multiple first display regions A1 can adopt the solution of combining external and internal manners to set pixel circuits.

In some examples, the pixel circuit connected to the light-emitting element of at least one first display region A1 can be set externally, and the pixel circuit connected to the light-emitting element of at least one of other first display regions A1 can be set internally. In multiple first display regions A1, some of the first display regions A1 adopt the external manner to set pixel circuits, and other first display regions A1 adopt the internal manner to set pixel circuits. For example, in two first display regions A1, in one first display region A1, the pixel circuits can be set externally, and in the other first display region A1, the pixel circuits can be set internally. For example, in three or more first display regions A1, in at least two of the first display regions A1, the pixel circuits can be set externally, and in other first display regions A1, the pixel circuits can be set internally.

In some examples, in multiple first display regions A1, at least one first display region A1 can adopt a combination of external and internal manners to set pixel circuits, at least another first display region A1 can adopt the internal manner to set pixel circuits, and at least another first display region A1 can adopt the external manner to set pixel circuits. For example, in three first display regions A1, the first display region A1 can adopt a combination of external and internal manners to set pixel circuits, the second first display region A1 can adopt the internal manner to set pixel circuits, and the third first display region A1 can adopt the external manner to set pixel circuits. For example, in three or more first display regions A1, at least two of the first display regions A1 can adopt a combination of external and internal manners to set pixel circuits, another first display region A1 can adopt the internal manner to set pixel circuits, and the remaining first display regions A1 can adopt the external manner to set pixel circuits. For example, among three or more first display regions A1, at least two of the first display regions A1 can adopt the internal manner to set pixel circuits or the external manner to set pixel circuits, another first display region A1 can adopt a combination of external and internal manners to set pixel circuits, and the remaining first display regions A1 can adopt the external manner to set pixel circuits or the internal manner to set pixel circuits. In this way, multiple first display regions A1 with different light transmittance can be realized to meet different functional requirements.

In some examples, as shown in FIGs. 1 and 2, the three first display regions A1 may include: one first type display region A11, and two second type display regions A12 and A13. The three first display regions A1 can be sequentially arranged along the second direction X. The first type display region A11 can be located in the middle of the two second type display regions A12 and A13 in the second direction X. For example, the second type display region A12 may be located on one side of the first type display region A11 along the second direction X, and the second display region A13 may be located on the opposite side of the first type display region A11 along the second direction X, which is not limited in the present disclosure. In other examples, the first type display region A11, and two second type display regions A12 and A13 may be arranged sequentially along the second direction X or along the opposite direction of the second direction X. In other examples, multiple first display regions A1 may include a first type display region and a second type display region arranged along the first direction Y, or may include a first type display region and a second type display region arranged along the second direction X.

In some examples, as shown in FIGs. 1 and 2, the first type display region A11 and two second type display regions A12 and A13 may be sequentially connected along the arrangement direction (e.g., the second direction X), and the first display region A1 may be connected between the two second type display regions A12 and A13. The transition display region A2 can be located in a region outside the three first display regions A1, which is not limited in the present disclosure. In other examples, two adjacent first display regions A1 along the arrangement direction (e.g., the second direction X) may not be connected, and the adjacent first display regions A1 may be separated by a transition display region A2.

In some examples, as shown in FIGs. 1 and 2, the display region AA can be roughly rectangular. The display region AA may include the first display region A1, the transition display region A2, and the second display region A3, or the display region AA may only include the first display region A1 and the second display region A3. The number of the first display regions A1 can be one or more, such as two or three. As shown in FIG. 1, the shapes of the three first display regions A1 can be roughly the same, for example, the first type display region A11, and the two second type display regions A12 and A13 can all be circular or elliptical. In other examples, the shapes of multiple first display regions A1 may be partially same. The overall shape of the three first display regions A1 can be roughly rounded rectangle or ellipse, and the shape of the first type display region A11 can be roughly circular, and the center of the first type display region A11 can be the same as the center position of the overall shape of the three first display regions A1, which is not limited in the present disclosure. For example, the first display region can be rectangular, and the second display region can be circular or elliptical. In other examples, the shapes of the two second display regions may be different, for example, one second display region may have a rectangular shape, and the other second display region may have an elliptical or circular shape.

In some examples, the light transmittance of multiple first display regions A1 may be greater than or equal to the light transmittance of the second display region A3, and the light transmittance of the second display region A3 may be less than or equal to the light transmittance of the transition display region A2. For example, the light transmittance of the second display region A3 may be lower than the light transmittance of multiple first display regions A1, and higher than the light transmittance of the transition display region A2. Alternatively, the light transmittance of the second display region A3 may be lower than the light transmittance of the transition display region A2, and the light transmittance of the transition display region A2 may be lower than the light transmittance of multiple first display regions A1.

In some examples, the light transmittance of the first type display region A11 may be greater than or equal to the light transmittance of the second type display regions A12 and A13. For example, the light transmittance of the first type display region A11 may be greater than the light transmittance of the second type display regions A12 and A13, and the light transmittance of the second type display regions A12 and A13 may be approximately the same, or the light transmittance of the second type display region A12 may be greater than the light transmittance of the second type display region A13, or the light transmittance of the second type display region A12 may be lower than the light transmittance of the second type display region A13.

In some examples, the light transmittance of each region may include visible light transmittance and infrared light transmittance. For example, the infrared light transmittance of each region can be greater than or equal to the visible light transmittance. In this embodiment, visible light refers to the portion of the electromagnetic spectrum that can be perceived by the human eye, such as wavelengths between 380 and 780 nanometers (nm). Infrared light refers to electromagnetic waves in the infrared wavelength range between visible light and microwave, with a wavelength range of 780 to 3000 nanometers.

In some examples, the functions of multiple first display regions A1 may be different or partially the same. For example, the first type display region A11 can be configured to support visible light transmission, allowing the camera set under the screen to receive visible light and achieve photography or video recording functions. The orthographic projection of the camera on the display substrate can overlap at least partially with the first type display region A11. The functions of the second type display region A12 and A13 can be the same. For example, the second type display region A12 can be configured to support infrared light transmission, such that the infrared sensor set under the screen can transmit infrared light to achieve facial recognition and other functions using infrared light. For example, the orthographic projection of the infrared sensors on the display substrate can overlap at least partially with the second type display regions A12 and A13, which is not limited in the present disclosure. In other examples, the functions corresponding to two second type display regions may be different. For example, one second type display region can be configured to support distance sensing, and the other second type display region can be configured to support ambient light sensing.

In some examples, the ratio of resolution between the first display region A1 and the transition display region A2 may be approximately 0.8 to 1.2. For example, the resolution of the first display region A1 can be roughly the same as the resolution of the transition display region A2. The resolution of the second display region A3 can be roughly the same as the resolution of the transition display region A2, which is not limited in the present disclosure.

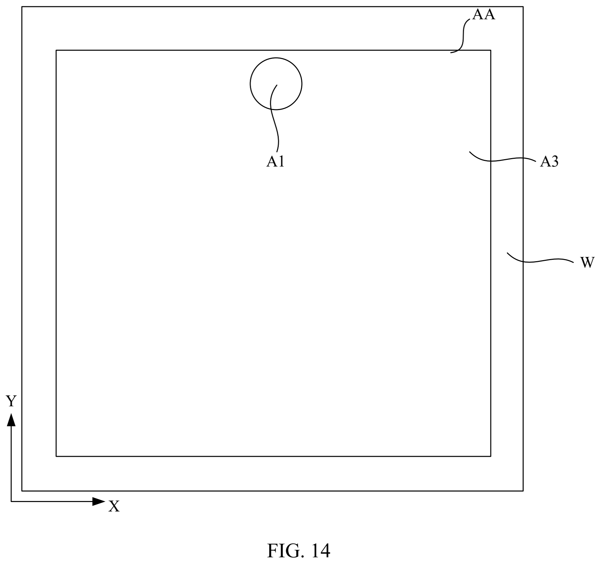

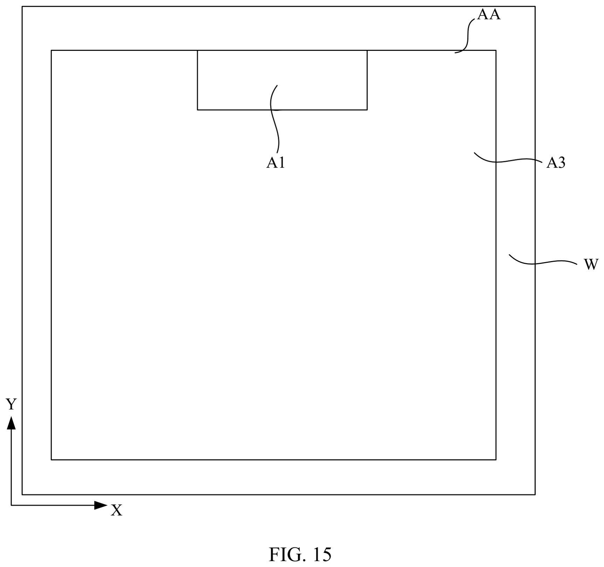

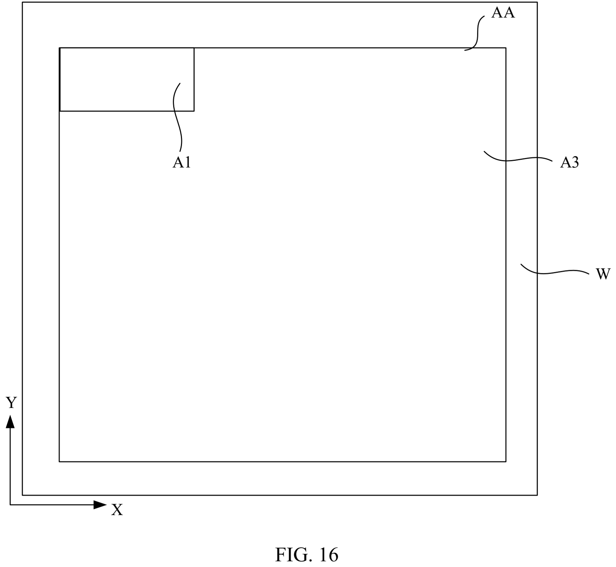

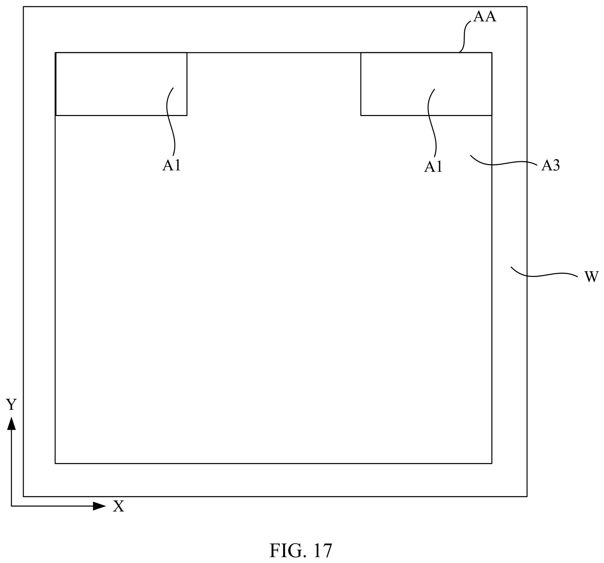

As shown in FIGs. 14-17, FIG. 14 is a schematic diagram of the first display region A1 being circular and set in the middle of the second display region A3, FIG. 15 is a schematic diagram of the first display region A1 being rectangular and set in the middle of the upper edge of the display region AA, FIG. 16 is a schematic diagram of the first display region A1 being rectangular and set in the corner of the edge of the display region AA, and FIG. 17 is a schematic diagram of the first display region A1 being two rectangles and set in the two corners of the edge of the display region AA. The first display region A1 can be set in the middle of the display region AA, and can be circular, elliptical, or square, etc. The first display regions A1 can also be set on the side of the display region AA, such as one or both sides. The present disclosure does not limit the arrangement position of multiple first display regions A1. Multiple first display regions A1 can also be set in the middle or around the display substrate. As long as the first display regions A1 is set on the display substrate, it should be within the protection scope of the present disclosure.

In an embodiment, the multiple transistors of the first pixel circuit 11 in the first display region A1 include oxide transistors 230, and do not include polycrystalline silicon transistors 210. All the transistors in the first display region A1 being oxide transistors 230 can maximize the transparency of the first display region A1. If the optical sensor is set under the first display region A1, the best effect can be obtained.

As shown in FIG. 3, which is a cross-sectional schematic diagram of A-A' in FIG. 2, the display substrate can roughly include a circuit layer 200, a light-emitting element, a pixel definition layer 300, and an encapsulation layer 700. The light-emitting element includes an anode 400, a cathode 500, and a light-emitting layer 600 located between the anode 400 and the cathode 500. The circuit layer 200 is connected to the light-emitting element, to drive the light-emitting element to emit light. The pixel definition layer 300 is configured to define the shape and size of the pixel. The cathode 500 is used to form a potential difference with the anode 400 to light up the light-emitting layer 600. The light-emitting layer 600 emits light or extinguishes under the cooperation of the anode 400 and the cathode 500. The encapsulation layer 700 is configured to encapsulate the screen.

The anode 400 is located under the light-emitting layer 600 in the thickness direction H of the screen, the pixel definition layer 300 is located on both sides of the anode 400 and the light-emitting layer 600, the circuit layer 200 is located under the anode and the pixel definition layer 300 in the thickness direction H of the screen, the cathode 500 is located on the light-emitting layer 600 and the pixel definition layer 300 in the thickness direction H of the screen, and the cathode 500 is sequentially provided with an encapsulation layer 700 in the thickness direction H of the screen. The pixel circuit layer 200 controls the light emitting element to control the light emission of the light emitting layer 600, and passes upward through the encapsulation layer 700.

In an embodiment, multiple transistors include oxide transistors 230 and polycrystalline silicon transistors 210, with the number of polycrystalline silicon transistors 210 being greater than the number of oxide transistors 230. The polycrystalline silicon transistor 210 has lower resistance and faster response speed compared to the oxide transistor 230. The mixed arrangement of the polycrystalline silicon transistor 210 and the oxide transistor 230 can ensure the transparency of the first display region A1 and maintain a relatively sensitive reaction speed of the first display region A1.

In an embodiment, the first pixel circuit 11 includes a driving transistor, where the driving transistor is a polycrystalline silicon transistor 210. The polycrystalline silicon transistor 210 is either a high-temperature polycrystalline silicon transistor 210 or a low-temperature polycrystalline silicon transistor 210. The driving transistor (such as driving thin film transistor, DTFT) is the largest among all transistors, and because the channel of the oxide transistor 230 is larger than the channel of the polycrystalline silicon transistor 210 under the same carrying capacity, replacing the driving transistor (DTFT) with the polycrystalline silicon transistor 210 can effectively reduce the overall region of the driving circuit, thereby improving the resolution of the screen.

The inventor found through extensive experiments that when the length of the channel of the driving transistor (DTFT) is less than or equal to 20um, the driving transistor (DTFT) is difficult to undertake the driving task; and when the length of the driving transistor (DTFT) is greater than or equal to 40um, the driving transistor (DTFT) is too large, which affects the resolution of the screen. Setting the driving transistor DTFT to a length greater than or equal to 20um and less than or equal to 40um can adapt to both driving tasks and corresponding screen resolutions. This embodiment sets the length of the driving transistor (DTFT) to be greater than or equal to 20um and less than or equal to 40um, which can adapt to the corresponding screen resolution and the driving task. In other embodiments, the length of the driving transistor (DTFT) can also be set to be greater than or equal to 10um and less than or equal to 100um.

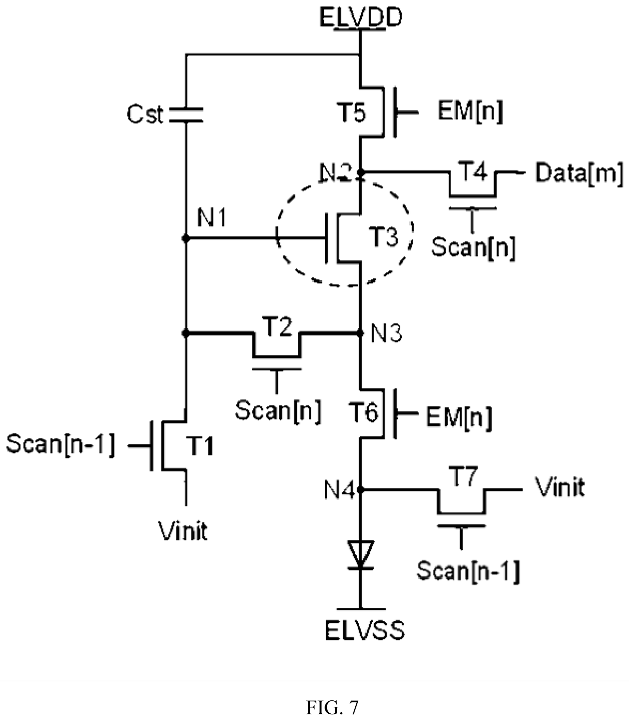

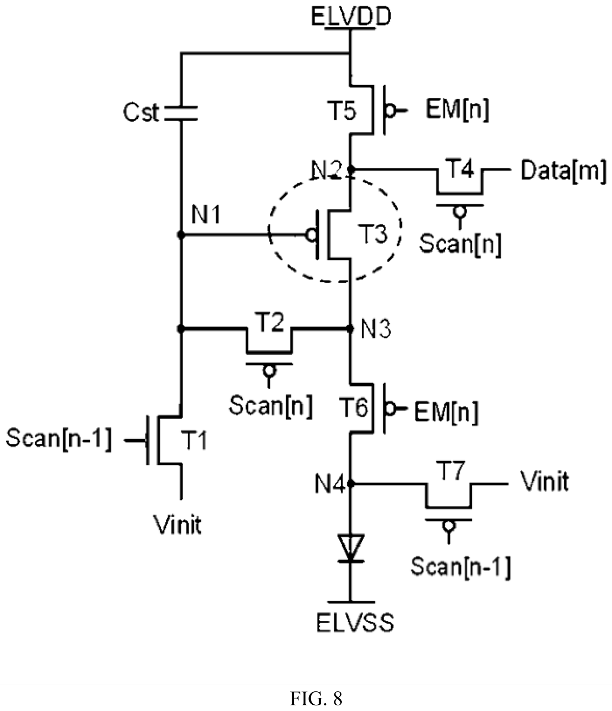

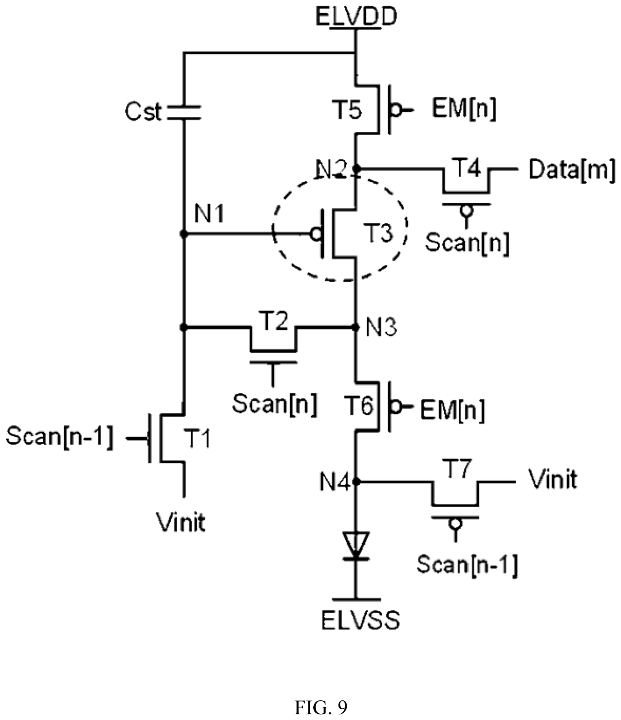

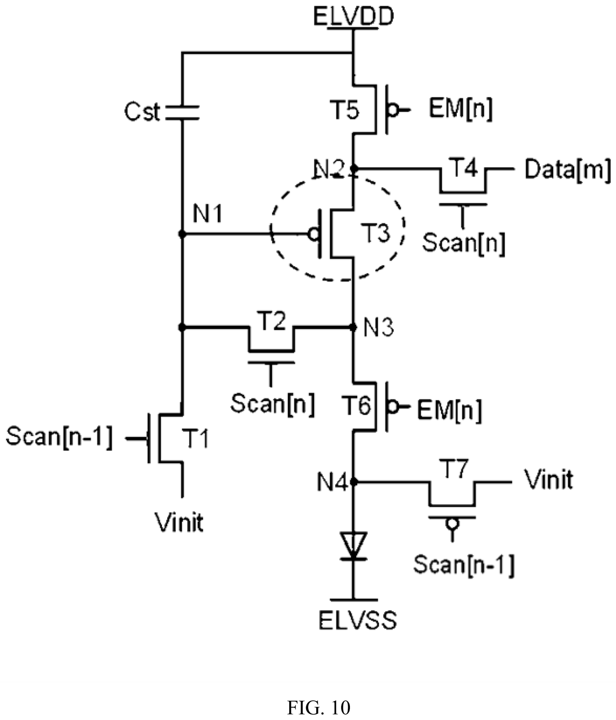

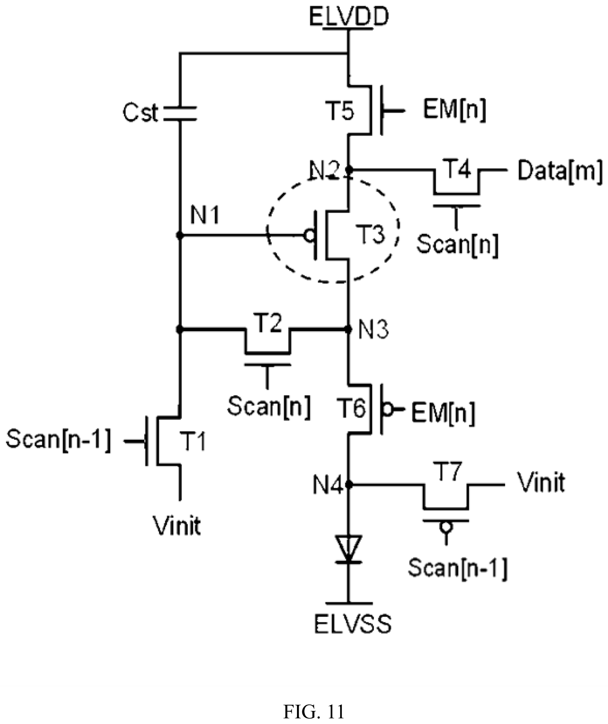

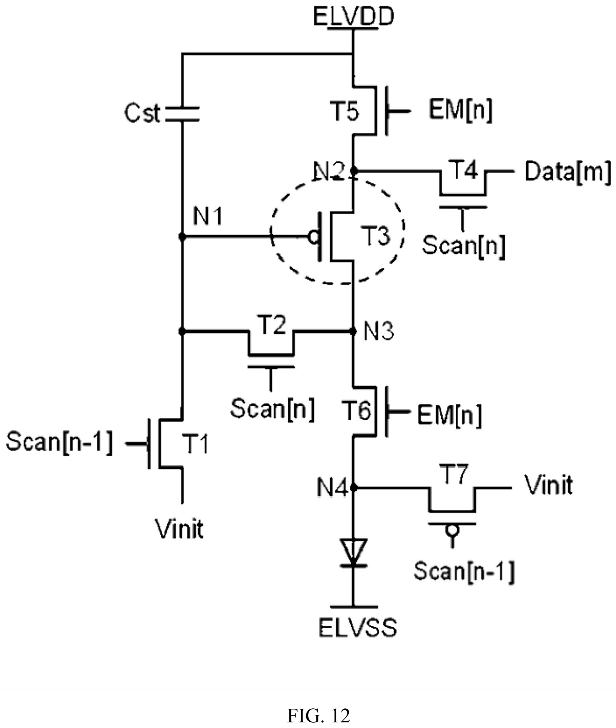

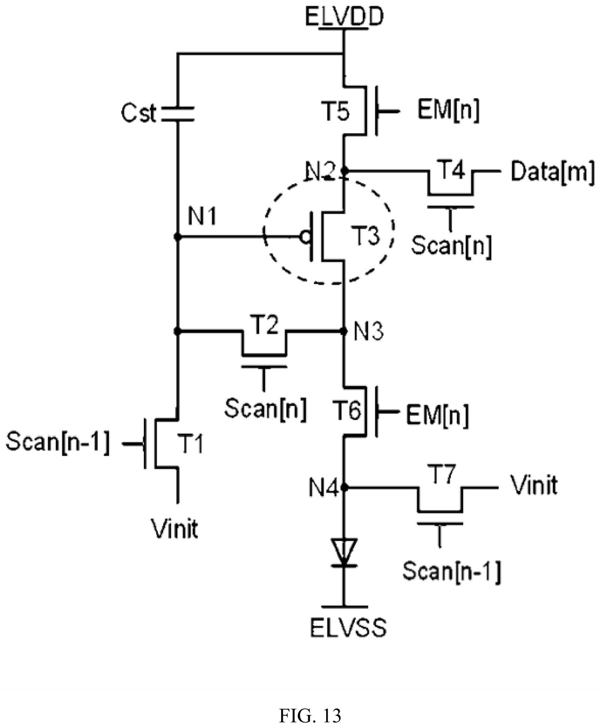

In an embodiment, referring to FIGs. 7-13, the first circuit transistor T1, second circuit transistor T2, third circuit transistor T3, fourth circuit transistor T4, fifth circuit transistor T5, sixth circuit transistor T6, and seventh circuit transistor T7 in FIG. 7 are all oxide transistors 230, and the second circuit transistor T2, third circuit transistor T3, fourth circuit transistor T4, fifth circuit transistor T5, sixth circuit transistor T6, and seventh circuit transistor T7 in FIG. 8 are all polycrystalline silicon transistors 210, such as low-temperature polycrystalline silicon transistor 210, and the first circuit transistor T1 in FIG. 8 is an oxide transistor 230. The third circuit transistor T3, fourth circuit transistor T4, fifth circuit transistor T5, sixth circuit transistor T6, and seventh circuit transistor T7 in FIG. 9 are all polycrystalline silicon transistors 210, such as low-temperature polycrystalline silicon transistor 210. The first circuit transistor T1 and the second circuit transistor T2 in FIG. 9 are oxide transistors 230. The third circuit transistor T3, the fifth circuit transistor T5, the sixth circuit transistor T6, and the seventh circuit transistor T7 in FIG. 10 are all polycrystalline silicon transistors 210, such as low-temperature polycrystalline silicon transistors 210. The first circuit transistor T1, the second circuit transistor T2, and the fourth circuit transistor T4 in FIG. 10 are all oxide transistors 230. In FIG. 11, the third circuit transistor T3, the sixth circuit transistor T6, and the seventh circuit transistor T7 are all polycrystalline silicon transistors 210, such as low-temperature polycrystalline silicon transistors 210. The first circuit transistor T1, the second circuit transistor T2, the fourth circuit transistor T4, and the fifth circuit transistor T5 in FIG. 11 are all oxide transistors 230. The third circuit transistor T3 and the seventh circuit transistor T7 in FIG. 12 are both polycrystalline silicon transistors 210, such as low-temperature polycrystalline silicon transistors 210. The first circuit transistor T1, the second circuit transistor T2, the fourth circuit transistor T4, the fifth circuit transistor T5, and the sixth circuit transistor T6 in FIG. 12 are all oxide transistors 230. The third circuit transistor T3 in FIG. 13 is a polycrystalline silicon transistor 210, such as a low-temperature polycrystalline silicon transistor 210. The first circuit transistor T1, the second circuit transistor T2, the fourth circuit transistor T4, the fifth circuit transistor T5, the sixth circuit transistor T6, and the seventh circuit transistor T7 in FIG. 13 are all oxide transistors 230. The first pixel circuit 11 includes a first circuit transistor T1, a second circuit transistor T2, and a third circuit transistor T3. The first electrode of the first circuit transistor T1, the gate of the third circuit transistor T3, and the second electrode of the second circuit transistor T2 are connected. The first electrode of the second circuit transistor T2 is connected to the second electrode of the third circuit transistor T3. The third circuit transistor T3 is a driving transistor. The third circuit transistor T3 can control the current of the first pixel circuit 11 to control the emission of light from the light-emitting layer.

Furthermore, the first circuit transistor T1 and the second circuit transistor T2 are oxide transistors 230. Due to the high transparency of the oxide transistor 230, the first circuit transistor T1 and the second circuit transistor T2 being the oxide transistor 230 can improve the transparency of the first display region A1.

In this embodiment, the first pixel circuit 11 further includes a power line ELVDD, a first initialization signal line Vinit, a second initialization signal line Vinit, and a data line Data (m). The first pixel circuit 11 includes a storage capacitor Cst, a fourth circuit transistor T4, a fifth circuit transistor T5, a sixth circuit transistor T6, and a seventh circuit transistor T7. The first electrode of the first circuit transistor T1 is connected to the first electrode plate of the storage capacitor Cst, the second electrode of the first circuit transistor T1 is connected to the first initialization signal line Vinit, the power line ELVDD is connected to the second electrode plate of the storage capacitor Cst and the first electrode of the fifth circuit transistor T5, the second electrode of the fifth circuit transistor T5 is connected to the first electrode of the third circuit transistor T3 and the second electrode of the fourth circuit transistor T4, the first electrode of the fourth circuit transistor T4 is connected to the data line Data (m), the first electrode of the second circuit transistor T2 is connected to the first electrode of the sixth circuit transistor, the second electrode of the sixth circuit transistor T6 is connected to the second electrode of the seventh circuit transistor T7, and the first electrode of the seventh circuit transistor T7 is connected to the second initialization signal line Vinit.

The circuit in this embodiment is a 7T1C circuit, and the user can control the illumination of the light-emitting transistor EL by controlling the power line ELVDD, the first initialization signal line Vinit, the second initialization signal line Vinit, and the data line Data (m).

Referring to FIG. 13, the third circuit transistor T3 is a polycrystalline silicon transistor 210, and the first circuit transistor T1, the second circuit transistor T2, the fourth circuit transistor T4, the fifth circuit transistor T5, the sixth circuit transistor T6, and the seventh circuit transistor T7 are all oxide transistors 230.

Based on the above settings, in this embodiment, only the third circuit transistor T3 is a polycrystalline silicon transistor 210, and all other transistors are oxide transistors 230, which can greatly enhance the transparency of the first display region A1 and ensure the circuit size.

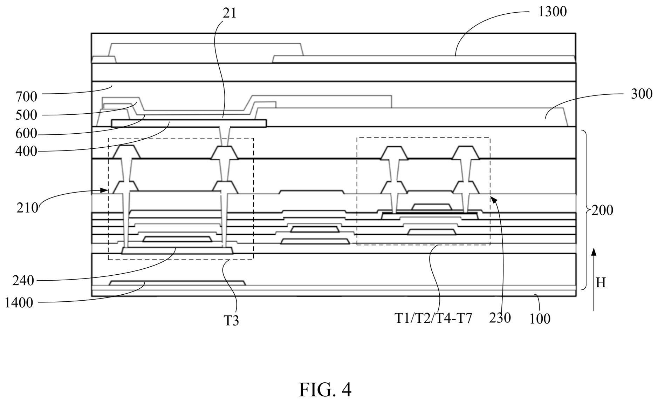

Furthermore, as shown in FIG. 4, FIG. 4 is a schematic cross-sectional diagram from B-B' in FIG. 2. The first light-emitting element 21 includes an anode 400, a light-emitting layer 600, and a cathode 500 arranged in sequence away from the first pixel circuit 11. The orthographic projection of the third circuit transistor T3 on the display substrate is located within the orthographic projection of the anode 400 on the display substrate.

From the respect of the thickness direction H of the display substrate, the transistors and wires located within the orthographic projection of the anode are completely blocked by the anode. Therefore, setting the transistors located within the orthographic projection of the anode as polycrystalline silicon transistors 210 will not affect the transparency of the transparent region 1100.

Because the oxide transistor 230 is larger than the polycrystalline silicon transistor 210 with the same carrying capacity, at least partially using the polycrystalline silicon transistor 210 under the anode can reduce the volume of the transistor.

The present disclosure not only includes the 7T1C driving circuit with the first circuit transistor T1, the second circuit transistor T2, the third circuit transistor T3, the fourth circuit transistor T4, the fifth circuit transistor T5, the sixth circuit transistor T6, the seventh circuit transistor T7, and the capacitor Cst mentioned above, but may further include the 8T1C driving circuit with the first circuit transistor T1, the second circuit transistor T2, the third circuit transistor T3, the fourth circuit transistor T4, the fifth circuit transistor T5, the sixth circuit transistor T6, the seventh circuit transistor T7, the eighth circuit transistor T8, and the capacitor Cst, as well as the 4T1C driving circuit with the first circuit transistor T1, the second circuit transistor T2, the third circuit transistor T3, the fourth circuit transistor T4, and the capacitor Cst. The connecting manner of these components will not be elaborated here. As long as the driving transistors (DTFT) of these components are replaced with polycrystalline silicon transistors 210, it should be within the protection scope of the present disclosure.

In an embodiment, referring to FIG. 3, where FIG. 7 shows the equivalent circuit diagram of FIG. 3, the third circuit transistor T3 includes an active layer 240, and a top gate 231 and a bottom gate 232 located on both sides of the active layer 240. The first electrode (drain) 233 and the second electrode (source) 234 of the third circuit transistor T3 are connected to the active layer 240, where the first electrode (drain) 233 and the second electrode (source) 234 of the third circuit transistor T3 are located on the side of the top gate 231 away from the active layer 240. A side of the second electrode 234 of the third circuit transistor T3 away from the active layer 240 is connected to the anode 400 through a transfer electrode 235. The display substrate further includes a first light shielding layer 1400. The first light shielding layer 1400 is located on the side of the active layer 240 away from the top gate 231, and the orthographic projection of the third circuit transistor T3 on the display substrate is within the orthographic projection of the first light shielding layer 1400 on the display substrate. The first light shielding layer 1400 here is set to block infrared light.

The inventor found in the experiment that the driving transistor (DTFT) of polycrystalline silicon transistor 210 is prone to current anomalies when exposed to infrared light. Therefore, the first light shielding layer 1400 is set to block the infrared light of the optical sensor to prevent current anomalies and ensure the stability of the display device.

In an embodiment, the first light shielding layer 1400 is at least partially set under the anode, and the first light shielding layer 1400 can block light, and the anode can also block light. If the first light shielding layer 1400 and the anode are arranged separately, from the perspective of the thickness direction of the display substrate, both the first light shielding layer 1400 and the anode block part of the light, thereby reducing the transparency of the display substrate. In this embodiment, the first light shielding layer 1400 is at least partially placed under the anode, which can increase the transparency of the display device compared to the separated arrangement of the first light shielding layer 1400 and the anode.

In some embodiments, the first light shielding layer 1400 is completely set under the anode. In this case, when viewed from the thickness direction H of the display substrate, only the anode can be seen in the first display region A1, and when viewed from the thickness direction H of the display substrate, the first light shielding layer 1400 is completely blocked, thereby achieving maximum transparency of the display device.

In an embodiment, the display substrate includes a second light shielding layer 1300. The orthographic projections of the first circuit transistor T1, the second circuit transistor T2, the fourth circuit transistor T4, the fifth circuit transistor T5, the sixth circuit transistor T6, and the seventh circuit transistor T7 on the display substrate is located within the orthographic projection of the second light shielding layer 1300 on the display substrate.

The inventor learned through experiments that visible light can have a certain impact on some types of oxide transistors 230 in the present disclosure, increasing the electron mobilities of these oxide transistors. Therefore, in this embodiment, the oxide transistor 230 is set to block visible light and allow infrared to pass through. This setting can enable the normal use of the oxide transistor 230 on one hand, and on the other hand, it can also enable the normal use of the optical sensor under the second light shielding layer 1300, such as the infrared sensor.

In an embodiment, both the first electrode and the second electrode of the storage capacitor Cst are made of transparent conductive material. Setting the storage capacitor Cst as a transparent conductive material, combined with the use of the oxide transistor 230 as described in the above embodiment, can further increase the transparency of the first display region A1.

Furthermore, the display substrate further includes a gate line Scan (n), a light emission control signal line EM (n), and a reset control signal line Scan (n-1). The gate line Scan (n) is connected to the gate of the second circuit transistor T2 and the gate of the fourth circuit transistor T4. The light emission control signal line EM (n) is connected to the gate of the fifth circuit transistor T5 and the gate of the sixth circuit transistor T6. The reset control signal line Scan (n-1) is connected to the gate of the first circuit transistor T1 and the gate of the seventh circuit transistor T7. By controlling the connection of the power line ELVDD, the first initialization signal line Vinit, the second initialization signal line Vinit, the data line Data (m), the gate line Scan (n), the light emission control signal line EM (n), and the reset control signal line Scan (n-1), the on and off of the light emitting device can be controlled.

In an embodiment, at least one of the power line ELVDD, the first initialization signal line Vinit, the second initialization signal line Vinit, the data line Data (m), the gate line Scan (n), the light emission control signal line EM (n), and the reset control signal line Scan (n-1) is made of a transparent conductive material.

The transparent conductive material here can be selected from materials such as indium tin oxide (ITO), or zinc oxide (IZO), etc. Because materials such as indium tin oxide (ITO) and zinc oxide (IZO) have high transparency compared to metal wires, display substrates made of these materials have high transparency.

Users can control the illumination of the light-emitting element (such as the first light-emitting element 21) by controlling the power line ELVDD, the first initialization signal line Vinit, the second initialization signal line Vinit, the data line Data (m), the gate line Scan (n), the light emission control signal line EM (n), and the reset control signal line Scan (n-1).

In some embodiments, the power line ELVDD, the first initialization signal line Vinit, the second initialization signal line Vinit, the data line Data (m), the gate line Scan (n), the light emission control signal line EM (n), and the reset control signal line Scan (n-1) are all made of transparent conductive materials. When the above materials are all transparent conductive materials, the first display region A1 can achieve maximum transparency.

In an embodiment, the first light-emitting element 21 includes an anode 400, a light-emitting layer 600, and a cathode 500 arranged sequentially away from the first pixel circuit 11. The orthographic projections of at least some segments of the power line ELVDD, the first initialization signal line Vinit, the second initialization signal line Vinit, the data line Data (m), the gate line Scan (n), the light emission control signal line EM (n), and the reset control signal line Scan (n-1) on the display substrate overlap with the orthographic projection of the anode 400 on the display substrate. The at least some segments overlapping with the anode 400 are made of metal material, and the remaining segments are made of transparent conductive material.

Due to the higher resistance of transparent conductive materials compared to metal materials, replacing transparent conductive materials with metal materials can improve conductivity. The anode 400 is made of opaque material, such that replacing, with metal material, the overlapping segments of the power line ELVDD, the first initialization signal line Vinit, the second initialization signal line Vinit, the data line Data (m), the gate line Scan (n), the light emission control signal line EM (n), and the reset control signal line Scan (n-1) with the anode 400 will not affect the overall transparency of the first display region A1.

In summary, in this embodiment, the power line ELVDD, the first initialization signal line Vinit, the second initialization signal line Vinit, the data line Data (m), the gate line Scan (n), the light emission control signal line EM (n), and the reset control signal line Scan (n-1) are replaced with metal materials at the intersection with the anode 400, which does not affect the overall transparency of the first display region A1 and can improve the conductivity.

In some examples, the pixel circuit may include multiple transistors and at least one capacitor. For example, pixel circuits can be 3T1C, 4T1C, 5T1C, 5T2C, 6T1C, 7T1C, or 8T1C structures. Where T in the above circuit structure refers to thin film transistors, C refers to capacitors, the number before T represents the number of thin film transistors in the circuit, and the number before C represents the number of capacitors in the circuit.

In some examples, multiple transistors in a pixel circuit may be P-type transistors or N-type transistors. The use of the same type of transistors in pixel circuits can simplify the process flow, reduce the process difficulty of display substrates, and improve product yield. In other examples, multiple transistors in a pixel circuit may include P-type transistors and N-type transistors.

In some examples, multiple transistors in a pixel circuit may use polycrystalline silicon transistors 210, or may use oxide transistors 230, or may use polycrystalline silicon transistors 210 and oxide transistors 230. The active layer 240 of the polycrystalline silicon transistor 210 uses low-temperature polycrystalline silicon material (LTPS), and the active layer of the oxide transistor 230 uses oxide semiconductor material (Oxide). The polycrystalline silicon transistor 210 has advantages such as high mobility and fast charging, and the oxide transistor 230 has advantages such as low leakage current. Integrating the polycrystalline silicon transistor 210 and the oxide transistor 230 on one display substrate, i.e., the LTPS+Oxide (LTPO) display substrate, can utilize the advantages of both to achieve low-frequency driving, reduce power consumption, and improve display quality.

In some examples, the light emitting elements may be any one of light emitting diodes (LEDs), organic light emitting diodes (OLEDs), quantum dot light emitting diodes (QLEDs), micro LEDs (including mini LEDs or micro LEDs), etc. For example, the light-emitting element can be an OLED. The light-emitting element can emit red, green, blue, or white light under the driving of the corresponding pixel circuit. The color of the light emitted by the light-emitting element can be determined according to the needs. In some examples, the light-emitting element may include an anode, a cathode, and an organic light-emitting layer between the anode and cathode. The anode of the light-emitting element can be electrically connected to the corresponding pixel circuit, which is not limited in the present disclosure.

In some examples, the shape of the light-emitting element can be rectangular, diamond shaped, pentagonal, hexagonal, or other irregular shapes. The light-emitting elements of four sub pixels in a pixel unit can be arranged horizontally, vertically, or in a square pattern, which is not limited in the present disclosure. In other examples, a pixel unit may include three sub pixels, and the light-emitting elements of the three sub pixels may be arranged horizontally, vertically, or in a zigzag pattern.

In an embodiment, as shown in FIGs. 1 and 2, the display substrate further includes multiple second sub pixels in the second display region A3. The second sub pixels include a second light emitting element 22 and a second pixel circuit 12. The second pixel circuit 12 is configured to drive the second light emitting element 22 to emit light. The second pixel circuit 12 includes multiple transistors, including an oxide transistor 230 and/or a polycrystalline silicon transistor 210.

The second display region A3 and the first display region A1 cooperate to display screen images. The present disclosure does not limit the second pixel circuit 12 to be an oxide transistor 230 or a polycrystalline silicon transistor 210. Therefore, as long as it can perform light-emitting display and has a second sub-pixel, it should be within the scope of protection of the present disclosure.

In an embodiment, referring to FIGs. 1 and 2, the display substrate further includes a transition display region A2 between the at least one first display region A1 and the second display region A3, and the transition display region A2 surrounds the at least one first display region A1. The display substrate further includes multiple third sub pixels in the transition display region A2. The third sub pixel includes a third light-emitting element 23 and a third pixel circuit 13. The third pixel circuit 13 is configured to drive the third light-emitting element 23 to emit light. The display substrate includes a power line ELVDD, a first initialization signal line Vinit, a second initialization signal line Vinit, a data line Data (m), a gate line Scan (n), a light emission control signal line EM (n), and a reset control signal line Scan (n-1) connected to the third pixel circuit 13. The power line ELVDD, the first initialization signal line Vinit, the second initialization signal line Vinit, the data line Data (m), the gate line Scan (n), the light emission control signal line EM (n), and the reset control signal line Scan (n-1) are metal wires, and the third pixel circuit 13 uses the same transistor as the first pixel circuit 11.

Because the resistance of metal wires is lower than the resistance of transparent wires, the power line ELVDD, first initialization signal line Vinit, second initialization signal line Vinit, data line Data (m), gate line Scan (n), light emission control signal line EM (n), and reset control signal line Scan (n-1) connected to the third pixel circuit 13 are set as metal wires to minimize resistance.

The circuit layer 200 is generally driven by an external GOA (Gate Driver on Array). If the third pixel circuit 13 and the first pixel circuit 11 use the same type of transistor, the same type of GOA can be used for driving. Compared to different types of transistors, the arrangement is simpler. It should be noted that the same type of transistor here can be either an oxide transistor 230 or a polycrystalline silicon transistor 210.

In an embodiment, the pixel density of multiple second sub pixels is greater than the pixel density of multiple first sub pixels, and the pixel density of multiple second sub pixels is greater than the pixel density of multiple third sub pixels. Alternatively, the pixel density of multiple second sub pixels is greater than the pixel density of multiple third sub pixels, and the pixel density of multiple third sub pixels is greater than the pixel density of multiple first sub pixels.

It can be known that the higher the density of pixels, the lower their transparency. Therefore, in this embodiment, the density of the first sub-pixel is set to be smaller than the density of the second sub-pixel, which can further increase the transparency of the first display region A1.

The pixel density of the second sub-pixel is set to be greater than the pixel density of the third sub-pixel, and the pixel density of the third sub-pixel is set to be greater than the pixel density of the first sub-pixel, which can make the pixel density change in a gradient to implement smoothly transition, and prevent display boundaries in several regions.

Furthermore, the transmittance of the second display region A3 is lower than the transmittance of the transition display region A2, and the transmittance of the transition display region A2 is lower than the transmittance of at least one first display region A1. Setting the transmittance of the first display region A1, transition display region A2, and second display region A3 according to a gradient can ensure the continuity of their transmittance changes. On the other hand, because the transition display region surrounds the first display region A1, some light will enter below the first display region A1 from the transition display region, thereby ensuring that the optical sensor under the first display region A1 can collect more optical information.

In an embodiment, the number of first display regions A1 is 2 or 3. In practical usage scenarios, setting 2 or 3 first display regions A1 can arrange 2 or 3 optical sensors correspondingly. For example, deploying distance sensors, cameras, and infrared sensors to achieve more accurate facial recognition.

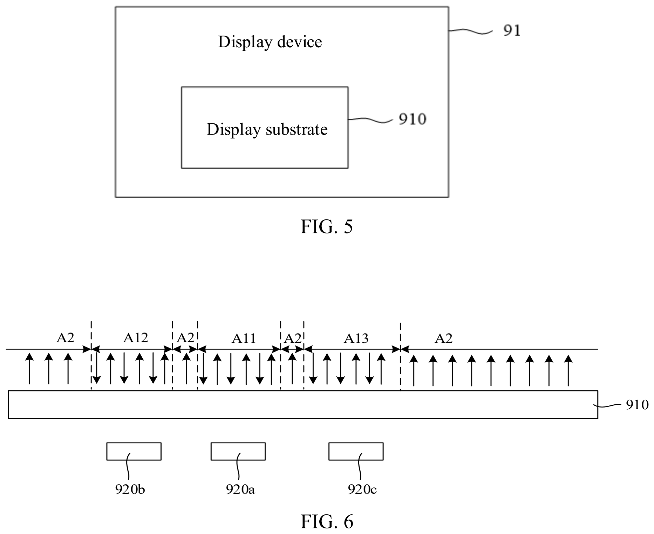

Referring to FIG. 5, the present disclosure further proposes a display device 91, including a display substrate 910, where the display substrate 910 is the display substrate described in the above embodiment. The display device 91 further includes at least one optical sensor, and at least one first display region A1 is set respectively corresponding to at least one optical sensor. In some examples, the display substrate 910 may be a flexible OLED display substrate, QLED display substrate, Micro LED display substrate, or Mini LED display substrate. The display device 91 can be a product with the function of displaying image (including static images or dynamic images, where the dynamic images can be videos). For example, the display device 91 can be any of the following products: a monitor, television, billboard, digital photo frame, laser printer with display function, telephone, mobile phone, picture screen, personal digital assistant (PDA), digital camera, portable camcorder, viewfinder, navigation device, vehicle, large region wall, information query equipment (such as business query equipment for e-government, banking, hospitals, electricity and other departments), monitor, etc. For example, the display device 91 can be a microdisplay, any product including VR devices or AR devices with microdisplays.

In some examples, as shown in FIG. 6, which is a partial cross-sectional schematic diagram of a display device, the display device may include three optical sensors 920a, 920b, and 920c. The three first type display regions can respectively correspond to the three optical sensors. The orthographic projection of the optical sensor 920a on the display substrate 910 can overlap with the first type display region A11, the orthographic projection of the optical sensor 920b on the display substrate 910 can overlap with the second type display region A12, and the orthographic projection of the optical sensor 920c on the display substrate 910 can overlap with the third type display region A13.

Optical sensors include ambient light sensors, distance sensors, camera sensors, infrared projectors, infrared sensors, etc. Optical sensors can be one of them to achieve a single function, or multiple combinations of them to achieve multiple functions.

For example, optical sensor 920a can be a camera, optical sensor 920b can be an infrared transmitter, and optical sensor 910c can be an infrared receiver. The infrared transmitter and the infrared receiver are used in conjunction for infrared recognition, such as facial recognition. The light transmittance of the first type display region A11 corresponding to the optical sensor 920a can be greater than the light transmittance of the second type display regions A12 and A13, such that under screen photography and video recording functions can be achieved. The infrared light transmittance of the second type display regions A12 and A13 can be greater than the visible light transmittance, thereby achieving the emission and reception of infrared light, such as for facial recognition, which is not limited in the present disclosure. In other examples, the three optical sensors 920a, 920b, and 920c may all be cameras, and the light transmittance of the first type display region A11, the second type display region A12, and A13 may be the same or different. In other examples, the three optical sensors 920a, 920b, and 920c may all be sensors, such as infrared sensors. The infrared transmittance of the first type display region A11, the second type display regions A12 and A13 may be greater than the visible transmittance. In other examples, the three optical sensors can be other types of sensors, such as distance sensors or ambient light sensors.

In the present disclosure, the structural embodiments and method embodiments can complement each other without conflict.

The above description is intended to be illustrative rather than restrictive. For example, the above examples (or one or more of their solutions) can be used in combination with each other. For example, those skilled in the art can use other embodiments when reading the above description. In addition, in the above embodiments, various features can be grouped together to simplify the present disclosure, which should not be interpreted as an intention that a disclosed feature that does not require protection is necessary for any claim. On the contrary, the subject matter in the present disclosure may be less than all features of a disclosed embodiment. Therefore, the following claims are incorporated into the embodiments as examples or implementation, where each claim is independently treated as a separate embodiment, and it is considered that these embodiments can be combined with each other in various combinations or arrangements. The scope of the present disclosure should be determined with reference to the accompanying claims and the equivalent forms of authorization claimed by these claims.

In the present disclosure, the terms "first" and "second" are only used for descriptive purposes and should not be understood as indicating or implying relative importance. The term "plurality of" and "several" means two or more, unless otherwise clearly defined.

Those skilled in the art will easily come up with other implementations of the present disclosure after considering the specification and practice of the present disclosure. The present disclosure is intended to cover any modification, use or adaptation of the present disclosure. These modifications, uses or adaptations follow the general principles of the present disclosure and include common knowledge and conventional technical means in the technical field that are not disclosed in the present disclosure. The specification and embodiments herein are intended to be illustrative only and the real scope and spirit of the present disclosure are indicated by the following claims of the present disclosure.

It is to be understood that the present disclosure is not limited to the precise structures described above and shown in the accompanying drawings and may be modified or changed without departing from the scope of the present disclosure. The scope of the present disclosure is limited only by the attached claims.

## Claims

1. A display substrate, comprising: at least one first display region, a second display region on at least one side of the at least one first display region, wherein light transmittance of the second display region is lower than light transmittance of the at least one first display region; and
first sub pixels in the at least one first display region, wherein each of the first sub pixels comprises a first light-emitting element and a first pixel circuit, wherein the first pixel circuit is configured to drive the first light-emitting element to emit light;
wherein the first pixel circuit comprises transistors, wherein at least one of the transistors is an oxide transistor.

2. The display substrate according to claim 1, wherein the transistors comprise oxide transistors and do not comprise polycrystalline silicon transistors.

3. The display substrate according to claim 1, wherein the transistors comprise oxide transistors and polycrystalline silicon transistors, and a number of the polycrystalline silicon transistors is greater than a number of the oxide transistors.

4. The display substrate according to claim 1, wherein the first pixel circuit comprises a driving transistor, wherein the driving transistor is a polycrystalline silicon transistor.

5. The display substrate according to claim 4, wherein a length of a channel of the driving transistor is greater than or equal to 20um and less than or equal to 40um.

6. The display substrate according to claim 1, wherein the first pixel circuit comprises a first circuit transistor, a second circuit transistor, and a third circuit transistor, wherein a first electrode of the first circuit transistor, a gate of the third circuit transistor, and a second electrode of the second circuit transistor are connected, a first electrode of the second circuit transistor is connected to a second electrode of the third circuit transistor, and the third circuit transistor is a driving transistor.

7. The display substrate according to claim 6, wherein the first circuit transistor and the second circuit transistor are oxide transistors.

8. The display substrate according to claim 6, wherein the first pixel circuit further comprises a power line, a first initialization signal line, a second initialization signal line, and a data line;
wherein the first pixel circuit comprises a storage capacitor, a fourth circuit transistor, a fifth circuit transistor, a sixth circuit transistor, and a seventh circuit transistor, wherein a first electrode of the first circuit transistor is connected to a first electrode plate of the storage capacitor, a second electrode of the first circuit transistor is connected to the first initialization signal line, the power line is connected to a second electrode plate of the storage capacitor and a first electrode of the fifth circuit transistor, a second electrode of the fifth circuit transistor is connected to a first electrode of the third circuit transistor and a second electrode of the fourth circuit transistor, a first electrode of the fourth circuit transistor is connected to the data line, the first electrode of the second circuit transistor is connected to the first electrode of the six circuit transistor, a second electrode of the sixth circuit transistor is connected to a second electrode of the seventh circuit transistor, and a first electrode of the seventh circuit transistor is connected to the second initialization signal line.

9. The display substrate according to claim 8, wherein the third circuit transistor is a polycrystalline silicon transistor, and the first circuit transistor, the second circuit transistor, the fourth circuit transistor, the fifth circuit transistor, the sixth circuit transistor, and the seventh circuit transistor are oxide transistors.

10. The display substrate according to claim 9, wherein the third circuit transistor comprises an active layer, a gate on a side of the active layer, a first electrode and a second electrode of the third circuit transistor that are on a side of the gate away from the active layer, wherein the first electrode and the second electrode of the third circuit transistor are connected to the active layer; and
the display substrate further comprises a first light shielding layer, wherein the first light shielding layer is on a side of the active layer away from the gate, and an orthographic projection of the third circuit transistor on the display substrate is within an orthographic projection of the first light shielding layer on the display substrate.

11. The display substrate according to claim 9, wherein the first light-emitting element comprises an anode, a light-emitting layer, and a cathode that are arranged sequentially away from the first pixel circuit;
wherein an orthographic projection of the third circuit transistor on the display substrate is within an orthographic projection of the anode on the display substrate.

12. The display substrate according to claim 8, wherein the display substrate comprises a second light shielding layer, wherein orthographic projections of the first circuit transistor, the second circuit transistor, the fourth circuit transistor, the fifth circuit transistor, the sixth circuit transistor, and the seventh circuit transistor on the display substrate is within an orthographic projection of the second light shielding layer on the display substrate.

13. The display substrate according to claim 8, wherein a first electrode and a second electrode of the storage capacitor are both made of transparent conductive materials.

14. The display substrate according to claim 8, further comprising: a gate line, a light emission control signal line, and a reset control signal line, wherein the gate line is connected to a gate of the second circuit transistor and a gate of the fourth circuit transistor; the light emission control signal line is connected to a gate of the fifth circuit transistor and a gate of the sixth circuit transistor; and the reset control signal line is connected to a gate of the first circuit transistor and a gate of the seventh circuit transistor.

15. The display substrate according to claim 14, wherein at least one of the power line, the first initialization signal line, the second initialization signal line, the data line, the gate line, the light emission control signal line, and the reset control signal line is made of a transparent conductive material.

16. The display substrate according to claim 15, wherein all of the power line, the first initialization signal line, the second initialization signal line, the data line, the gate line, the light emission control signal line, and the reset control signal line are made of transparent conductive materials.

17. The display substrate according to claim 14, wherein the first light-emitting element comprises an anode, a light-emitting layer, and a cathode that are arranged sequentially away from the first pixel circuit;
wherein orthographic projections of at least some segments of the power line, the first initialization signal line, the second initialization signal line, the data line, the gate line, the light emission control signal line, and the reset control signal line on the display substrate overlap with the orthographic projection of the anode on the display substrate, wherein the at least some segments overlapping with the anode are made of metal materials, and remaining segments are made of transparent conductive materials.

18. The display substrate according to any one of claims 1-17, wherein the display substrate further comprises second sub pixels in the second display region, wherein each of the second sub pixels comprising a second light emitting element and a second pixel circuit, wherein the second pixel circuit is configured to drive the second light emitting element to emit light;
wherein the second pixel circuit comprises transistors, wherein the transistors of the second pixel circuit comprise oxide transistors and/or polycrystalline silicon transistors.

19. The display substrate according to claim 18, further comprising a transition display region between the at least one first display region and the second display region, wherein the transition display region surrounds the at least one first display region; and
the display substrate further comprises third sub pixels located in the transition display region, wherein each of the third sub pixels comprise a third light emitting element and a third pixel circuit, wherein the third pixel circuit is configured to drive the third light emitting element to emit light; and
wherein the third pixel circuit comprises a power line, a first initialization signal line, a second initialization signal line, a data line, a gate line, a light emission control signal line, and a reset control signal line, wherein the power line, the first initialization signal line, the second initialization signal line, the data line, the gate line, the light emission control signal line, and the reset control signal line in the third pixel circuit are metal wires, and the third pixel circuit uses same transistors as the first pixel circuit.

20. The display substrate according to claim 19, wherein a pixel density of the second sub pixels is greater than a pixel density of the first sub pixels, and the pixel density of the second sub pixels is greater than a pixel density of the third sub pixels; or
a pixel density of the second sub pixels is greater than a pixel density of the third sub pixels, and the pixel density of the third sub pixels is greater than a pixel density of the second sub pixels.

21. The display substrate according to claim 19, wherein a number of the first display regions is 2 or 3.

22. The display substrate according to claim 19, wherein transmittance of the second display region is lower than transmittance of the transition display region, and the transmittance of the transition display region is lower than transmittance of the at least one first display region.

23. A display device comprising the display substrate according to any one of claims 1 to 22;
wherein the display device further comprises at least one optical sensor, and the at least one first display region is set respectively corresponding to the at least one optical sensor.

24. The display device according to claim 23, wherein the at least one optical sensor is one or more of an ambient light sensor, a distance sensor, a camera sensor, or an infrared sensor.
